# EUROPEAN PATENT SPECIFICATION

(11) **EP 0 516 130 B1**
(45) Date of publication and mention of the grant of the patent: **24.11.1999**
(21) Application number: 92109066.8
(22) Date of filing: 29.05.1992
(51) Int. Cl.: G01R 31/36

(54) **Circuit for measuring battery current**
Schaltung zur Messung des Batteriestromes
Circuit pour mesurer le courant d'une pile

(30) Priority: 29.05.1991 JP 15213891
(43) Date of publication of application: 02.12.1992
(73) Proprietor: FUJITSU LIMITED, Kawasaki-shi, Kanagawa 211 (JP)
(72) Inventor: Goto, Seiji, c/o Fujitsu Kyushu Digital, Fukuoka-shi, Fukuoka 812 (JP); Tsunoda, Kazuaki, c/o Fujitsu Kyushu Digital, Fukuoka-shi, Fukuoka 812 (JP); Murayama, Yukio, c/o Fujitsu Limited, Kawasaki-shi, Kanagawa, 211 (JP)
(74) Representative: Lehn, Werner, Dipl.-Ing.

(56) References cited:
- EP-A- 0 216 662
- EP-A- 0 417 575
- DE-A- 4 103 470
- Internationale Elektronische Rundschau, 1973, vol. 5, pages 99-102

## Description

The present invention relates to a current measuring circuit for measuring discharging current and charging current of a battery, which is divided into first and second parts and is selectively connectable to a load such as an electronic apparatus or the like and a battery charger.

EP-A-0 216 662 describes a current measuring circuit for measuring discharging current and charging current of a battery comprising:
means for permitting the battery to be selectively connected to a load or a charger;
a measuring resistor for connection in series with said battery having a sufficiently low resistance value as not to substantially restrain the output current from said first battery;
a first differential amplifier for amplifying a potential difference between both ends of said measuring resistor, said first differential amplifier comprising a first operational amplifier, a first resistor connected between one end of said measuring resistor and one input terminal of said first operational amplifier, a second resistor connected between the one input terminal and the output terminal of said first operational amplifier, and a third resistor connected between the other end of said measuring resistor and the other input terminal of said first operational amplifier;
a fourth resistor connected between the other input terminal (+) of said first operational amplifier and ground;
means for interconnecting the one input terminal (-) and the other input terminal (+) of said first operational amplifier via a variable resistor;
a second differential amplifier for amplifying the potential difference between both ends of said measuring resistor, said second differential amplifier comprising a second operational amplifier, a further resistor connected between the other end of said measuring resistor and the one input terminal (+) of said second operational amplifier; and
said first resistor being connected between the one end of said measuring resistor and the other input terminal (-) of said second operational amplifier and another further resistor being connected between the other input terminal (-) of said second operational amplifier and ground.

Mobile terminals such as portable telephone sets are generally driven by a battery. Therefore, it is desirable to constantly measure the charge condition of the battery and to charge the battery when the residual capacity of the battery decreases. In such a battery as a nickel-cadmium battery, the voltage does not fall so much but the discharging current remarkably decreases when the residual capacity decreases. Accordingly, so-called residual capacity meters adapted to detect the discharging current of a battery to thereby measure the residual capacity of the battery have so far been in wide use. As a discharging current measuring circuit of the prior art, such a circuit, as disclosed for example in Japanese Laid-open Patent Publication No. 59-145485, in which a resistor is connected to the positive terminal of a battery and a voltage for detecting current is directly taken out from both ends of the resistor through an A/D converter has so far been used. With such a current measuring circuit, the current value I can be obtained by substituting the potential difference V between both ends of the resistor and the resistance value R in Ohm's law I = V/R.

In the prior art current measuring circuit, the discharging current of the battery is restrained by the inserted resistor, and therefore, there have been problems with such prior art current measuring circuit that it is not suitable for measuring the discharging current of a battery supplying a large current and it is unable to measure a wide range of currents.

There is also known such a type of current measuring circuit in which it is adapted such that the potential difference between both ends of a resistor for current detection is amplified by a differential amplifier before being output to an A/D converter. However, in correctly measuring the discharging current of a battery, an operational amplifier of an expensive low offset/low drift voltage type must be used in the differential amplifier. Hence, there has been a problem with this type that the current measuring circuit incurs an increase in cost.

An object of the present invention is to provide a current measuring circuit capable of correctly measuring the battery discharging current and charging current with an economical structure not using expensive parts.

In accordance with the present invention, there is provided a current measuring circuit for measuring discharging current and charging current of a battery divided into first and second parts and selectively connectable to a load or a charger;
comprising:
a measuring resistor for connection in series with said battery having a sufficiently low resistance value as not to substantially restrain the output current from said battery;
a first differential amplifier for amplifying a potential difference between both ends of said measuring resistor, said first differential amplifier comprising a first operational amplifier, a first resistor connected between one end of said measuring resistor and one input terminal of said first operational amplifier, a second resistor connected between the one input terminal and the output terminal of said first operational amplifier, a third resistor connected between the other end of said measuring resistor and the other input terminal of said first operational amplifier, a fourth resistor connected between the other input terminal of said first operational amplifier and ground; the resistance value of said first resistor being equal to the resistance value of said third resistor and the resistance value of said second resistor being equal to the resistance value of said fourth resistor; means for interconnecting the one input terminal and the other input terminal of said first operational amplifier through the first and third resistors; calculating means for calculating the difference between an output voltage from said first operational amplifier when the one input terminal and the other input terminal of said first operational amplifier are interconnected and an output voltage from said first operational amplifier when the one input terminal of said first operational amplifier is connected with the one end of said measuring resistor and the other input terminal of said first operational amplifier is connected with the other end of said measuring resistor; and
a second differential amplifier for amplifying the potential difference between both ends of said measuring resistor, said second differential amplifier comprising a second operational amplifier, a seventh resistor connected between the other end of said measuring resistor and one input terminal of said second operational amplifier, an eighth resistor connected between the one input terminal and the output terminal of said second operational amplifier, a ninth resistor connected between the one end of said measuring resistor and the other input terminal of said second operational amplifier, and a tenth resistor connected between the other input terminal of said second operational amplifier and ground, the resistance value of said seventh resistor being equal to the resistance value of said ninth resistor and the resistance value of said eighth resistor being equal to the resistance value of said tenth resistor, wherein the positive power-supply terminals of said first operational amplifier and of said second operational amplifier are connected with the positive voltage output terminal of the first battery part and the negative power-supply terminals of said first operational amplifier and of said second operational amplifier are grounded, wherein the negative voltage output terminal of the first battery part is connected to the one end of the measuring resistor and wherein the second battery part is connected in series with the measuring resistor at the other end thereof.

By using the offset/drift voltage for correcting the output voltage from the first operational amplifier at the time of current measurement, it becomes possible to attain accurate measurement of the discharging current and charging current of the battery without using an expensive operational amplifier of a low offset/low drift type.

Preferably, the current measuring circuit is provided with a series connection of a fifth resistor and a first switch connected in parallel with said second resistor, a series connection of a sixth resistor and a second switch connected in parallel with said fourth resistor, a series connection of an eleventh resistor and a third switch connected in parallel with said eighth resistor; and a series connection of a twelfth resistor and a fourth switch connected in parallel with said tenth resistor. Then, by closing the first and second switches, the gain of the first operational amplifier can be decreased and, hence, the amplification factor of the first differential amplifier can be made smaller. By switching the gains of the operational amplifier as described above, it becomes possible to achieve measurement of a wide range of currents from a small current to a large current.

The above and other objects, features and advantages of the present invention and the manner of realizing them will become more apparent, and the invention itself will best be understood from a study of the following description and appended claims with reference to the attached drawings.
In the drawings:
FIG. 1 is an explanatory circuit diagram of a first current measuring circuit for measuring battery discharging/charging current;
FIG. 2 is a circuit diagram of a second current measuring circuit for measuring battery discharging/ charging current;
FIG. 3 is a circuit diagram of a third current measuring circuit for measuring battery discharging/ charging current;
FIG. 4 is a circuit diagram of a fourth current measuring circuit for measuring battery discharging/charging current;
FIG. 5 is a circuit diagram of a fifth current measuring circuit for measuring battery discharging/ charging current;
FIG. 6 is a circuit diagram of a sixth current measuring circuit for measuring battery discharging/ charging current;
FIG. 7 is a circuit diagram of a seventh current measuring circuit for measuring battery discharging/ charging current;
FIG. 8 is a circuit diagram of an eighth current measuring circuit for measuring battery discharging/ charging current;
FIG. 9 is a circuit diagram of a ninth current measuring circuit for measuring battery discharging/ charging current;
FIG. 10 is a circuit diagram of a tenth current measuring circuit for measuring battery discharging/charging current;
FIG. 11 is a circuit diagram of an eleventh current measuring circuit for measuring battery discharging/ charging current; and
FIG. 12 is a circuit diagram of a current measuring circuit for measuring battery discharging/charging current according to an embodiment of the present invention.

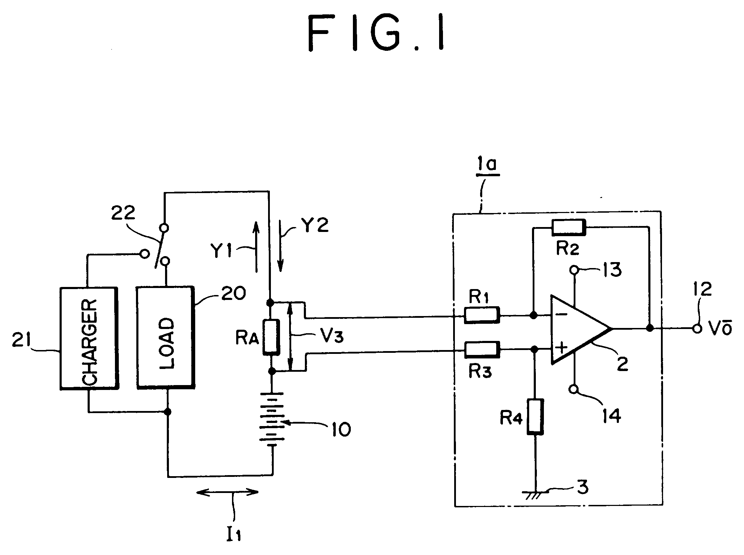

Referring first to FIG. 1, a first current measuring circuit will be described. Reference numeral 10 denotes a rechargeable battery such as a nickel-cadmium battery. By connecting a switch 22 to the side of a load 20 such as a portable telephone set, the load 20 comes to be driven by the battery 10. When the switch 22 is connected to the side of a battery charger 21, the battery 10 is charged.

On the positive electrode side of the battery 10, there is connected a resistor R_{A} in series with the battery. The resistor R_{A} has a sufficiently low resistance value as not to virtually restrain the output current from the battery. Preferably, the resistance value of the resistor R_{A} is set below 0.1Ω .

When the switch 22 is connected to the side of the load 20 and the load is driven by the battery 10, a current I₁ flows in the direction of the arrow Y1 (discharging direction). On the other hand, when the switch 22 is connected to the side of the charger 21, the current I₁ flows in the direction of the arrow Y2 (charging direction) and the battery 10 is thereby charged. As the current I₁ flowing out of the battery 10 or flowing into the battery 10 flows through the resistor R_{A}, there is generated a very small potential difference V₃ between both ends of the resistor R_{A} and this potential difference V₃ is applied to both inputs of a differential amplifier 1a.

The differential amplifier 1a comprises an operational amplifier 2. There are connected a first resistor R₁ between one input terminal (the inverting input terminal '-' in FIG. 1) of the operational amplifier 2 and one end of the resistor R_{A}, a second resistor R₂ between the inverting input terminal '-' and the output terminal of the operational amplifier 2, a third resistor R₃ between the other input terminal (the noninverting input terminal '+' in FIG. 1) of the operational amplifier 2 and the other end of the resistor R_{A}, and a fourth resistor R₄ between the noninverting input terminal '+' of the operational amplifier 2 and ground 3.

When the resistance values of the first to fourth resistors R₁ to R₄ are so set as to be R₁ = R₃ and R₂ = R₄ in the arrangement of the differential amplifier 1a as described above, the gain of the operational amplifier 2 comes to be determined by R₂/R₁ and this becomes the amplification factor of the differential amplifier 1a. Accordingly, by setting the resistance values of the resistors R₁ to R₄ at will under the conditions of R₁ = R₃ and R₂ = R₄, the amplification factor of the differential amplifier 1a can be set as desired.

The differential amplifier 1a amplifies the voltage V₃ applied thereto by the factor R₂/R₁ and outputs the amplified voltage from its output terminal 12 as a voltage V₀. The output voltage V₀ becomes a positive or a negative voltage depending on the direction of the current with respect to the battery 10. The voltage V₀ becomes positive when the current flows out of the battery 10 in the discharging direction (in the direction of the arrow Y1) and becomes negative when the current flows in the charging direction (in the direction of the arrow Y2).

Thus, by measuring the voltage V₀ with a measuring apparatus, which is not shown, the discharging current or charging current of the battery 10 can be measured. However, since the output voltage V₀ becomes positive or negative, it is required to apply a bias voltage to the A/D converter circuit in the measuring apparatus for determining the positive or negative polarity of the voltage V₀.

In the case of the circuit configuration shown in FIG. 1, operating power-supply voltages are applied to the positive power-supply terminal 13 and the negative power-supply terminal 14 of the operational amplifier 2. As the positive power-supply voltage, a positive voltage higher than the sum of the voltage of the battery 10 and the voltage of the potential difference V₃ is required, and as the negative power-supply voltage, a negative voltage lower than - V₃ is required. Accordingly, the positive power-supply terminal 13 is connected with a positive power supply, not shown, to supply such a positive voltage and the negative power-supply terminal 14 is connected with a negative power supply, not shown, to supply such a negative voltage.

When the load 20 such as a portable telephone set or the like is driven by the battery 10, the current I₁ flows in the direction of the arrow Y1 and thereby a very small potential difference V₃ is produced between both ends of the resistor R_{A}. The very small potential difference V₃ is multiplied in the differential amplifier 1a by the factor R₂/R₁ and output from the output terminal 12 as the voltage V₀. Then, the discharging current I₁ of the battery 10 can be measured by measuring the output voltage V₀. As the battery 10 is used up, the discharging current I₁ decreases, and therefore, by observing the discharging current, the timing for charging the battery 10 can be determined. When the battery 10 is used up, the switch 22 is connected to the side of the charger 21 and the battery 10 is charged. When the battery 10 is sufficiently charged, the charging current I₁ decreases and, hence, the output voltage V₀ of the differential amplifier 1a lowers. Therefore, the timing at which the battery 10 is fully charged can be determined by observing the output voltage V₀.

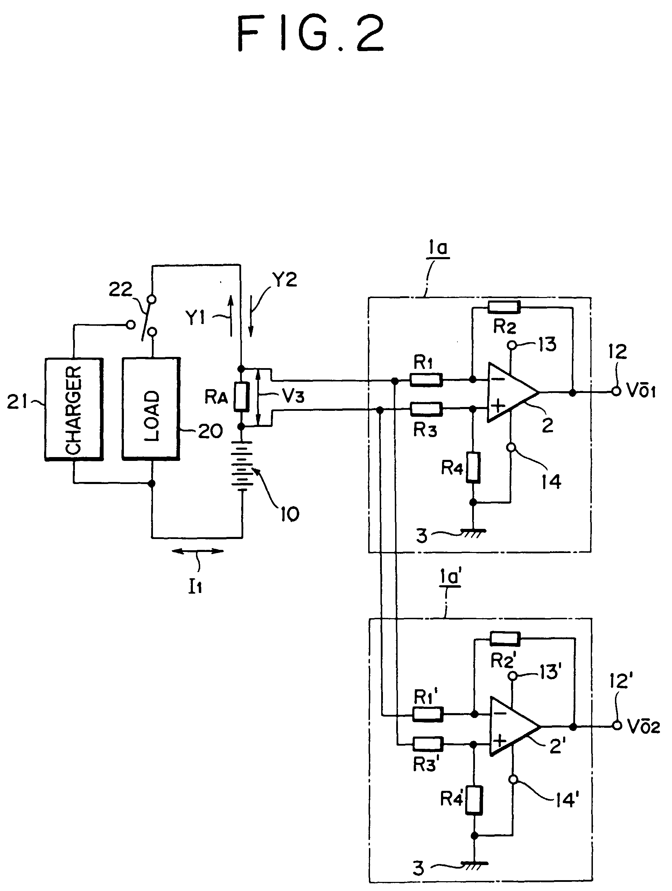

Referring to FIG. 2, there is shown a second current measuring circuit. The current measuring circuit in this embodiment is composed of two sets of the differential amplifiers la shown in FIG. 1. In order to distinguish between the two differential amplifiers, a single prime (') is attached to reference numerals of one differential amplifier.

The second current measuring circuit is arranged by interconnecting differential amplifiers 1a and 1a'. One end of the resistor R₁ of the differential amplifier la is connected with one end of the resistor R₃' of the differential amplifier 1a', while one end of the resistor R₃ is connected with one end of the resistor R₁'. Further, the negative power-supply terminals 14 and 14' of the operational amplifiers 2 and 2' are connected with ground 3.

In the described arrangement, when the discharging current I₁ of the battery 10 flows through the resistor R_{A}, a very small potential difference V₃ is generated between both ends of the resistor R_{A} and the voltage V₃ of the potential difference is applied between both the input terminals of the differential amplifiers 1a and 1a'. The voltage V₃ is amplified by the factor R₂/R₁ in the differential amplifier 1a and a positive voltage V₀₁ is output from the output terminal 12. At this time, the output voltage V₀₂ of the differential amplifier 1a' becomes 0 volt.

On the other hand, when the battery 10 is charged by the charger 21, the voltage V₃ of the potential difference due to the charging current I₁ is generated between both ends of the resistor R_{A}, and the voltage V₃ of the potential difference is applied between both the input terminals of the differential amplifiers 1a and 1a'. At this time, the output voltage V₀₁ of the differential amplifier la becomes 0 volt, while in the differential amplifier 1a', the voltage V₃ of the potential difference is amplified by the factor R₂'/R₁' and this voltage is output from the output terminal 12' as a positive voltage V₀₂. Thus, no matter whether in discharging direction or in charging direction the current may be flowing, the output voltage can be measured as a positive voltage. Hence, it becomes unnecessary to distinguish between positive and negative voltages as in the above described first circuit. Therefore, by measuring the positive voltage V₀₁ or V₀₂ with a measuring apparatus, the discharging current or charging current of the battery 10 can be measured. Since measurement of only positive voltage is made in the present circuit, negative power supplies as the operating power supplies for the operational amplifiers 2 and 2' are not required. That is, the negative power-supply voltage can be 0 V. Therefore, the negative power-supply terminals 14 and 14' of the operational amplifiers 2 and 2' can be connected to ground 3 as described above. Thus, the negative power supply can be eliminated and, hence, the power supply circuit can be simplified.

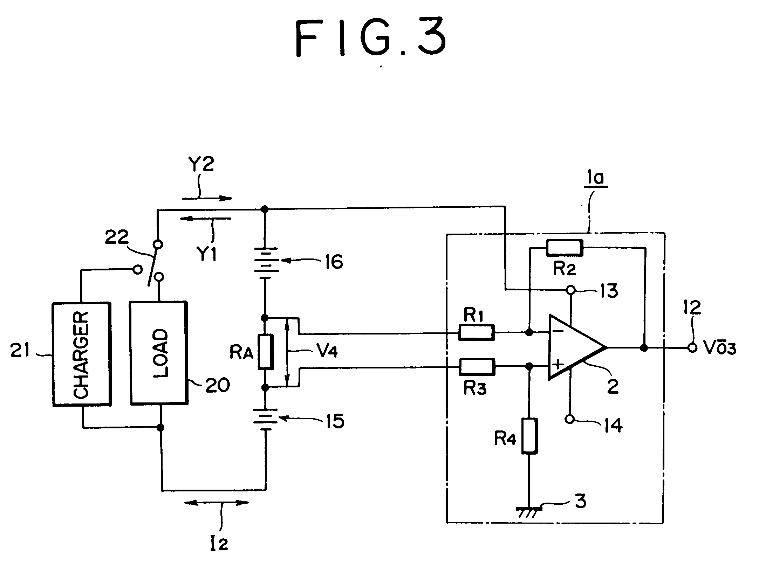

Referring to FIG. 3, there is shown a third current measuring circuit. In this third circuit, the battery 10 in the first and second circuits is divided into two batteries 15 and 16 and the resistor R_{A} is connected between the batteries 15 and 16 in series with them. The positive power-supply terminal 13 is connected with the positive side of the battery 16.

As a current I₂A₂ flowing out of or into the batteries 15 and 16 flows through the resistor R_{A}, a very small potential difference V₄ is generated between both ends of the resistor R_{A}. The potential difference V₄ is amplified by the differential amplifier 1a to be output therefrom as a positive or negative voltage V₀₃. As mentioned herein-above, the positive power-supply voltage as the operating power supply for the operational amplifier 2 is only required to be a voltage higher than the sum of the voltage of the battery 15 and the voltage of the potential difference V₄. Therefore, as shown in FIG. 3, the positive power-supply terminal 13 can be connected to the positive side of the battery 16 to thereby utilize the battery voltage. Thus, in the present circuit, a separate positive power supply can be eliminated and, hence, the power supply circuit can be simplified.

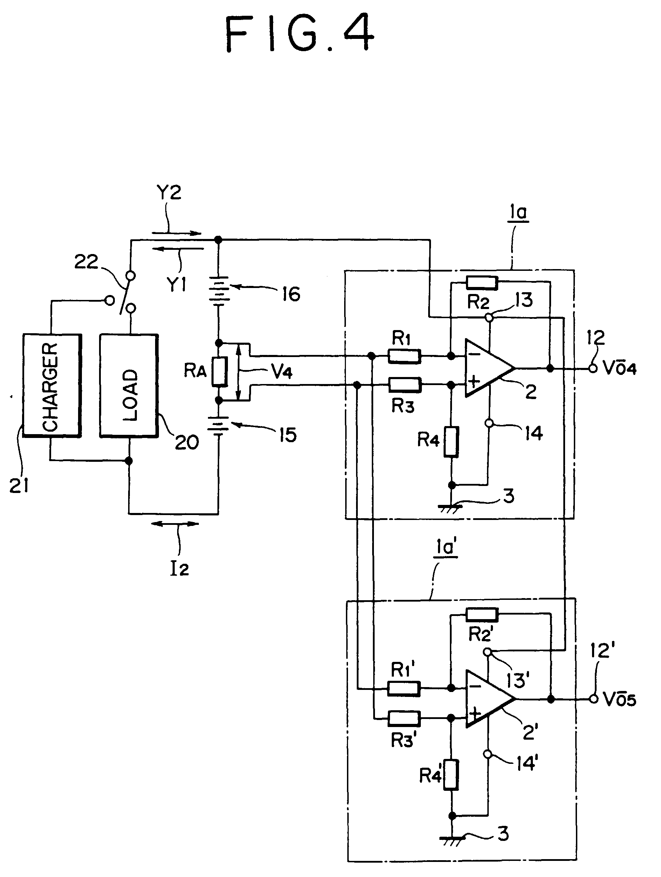

Referring to FIG. 4, there is shown a fourth current measuring circuit arranged by adding a differential amplifier 1a' to the current measuring circuit shown in FIG. 3. More specifically, one end of a resistor R₃' of the differential amplifier 1a' is connected to one end of the resistor R₁ of the differential amplifier la and one end of a resistor R₁' is connected to one end of the resistor R₃, and a positive power-supply terminal 13' of an operational amplifier 2' is connected to the positive side of the battery 16 the same as the positive power-supply terminal 13 of the operational amplifier 2.

In operation of the third current measuring circuit, as in the second circuit shown in FIG. 2, a positive output voltage V₀₄ is output from the output terminal 12 of the differential amplifier 1a when a discharging current flows out of the batteries 15 and 16, while a positive output voltage V₀₅ is output from the output terminal 12' of the differential amplifier 1a' when the batteries 15 and 16 are charged by the charger 21.

Therefore, the current flowing either in the discharging direction or in the charging direction can be measured as a positive voltage. Thus, the negative power-supply voltages for the operational amplifiers 2 and 2' can be 0 V and, hence, the negative power-supply terminals 14 and 14' can be connected to ground to eliminate the negative power supply. Further, since voltages of the batteries 15 and 16 can be utilized as the positive power supplies for the operational amplifiers 2 and 2', no positive and negative power-supply apparatuses are required to be additionally provided for driving the operational amplifiers 2 and 2'.

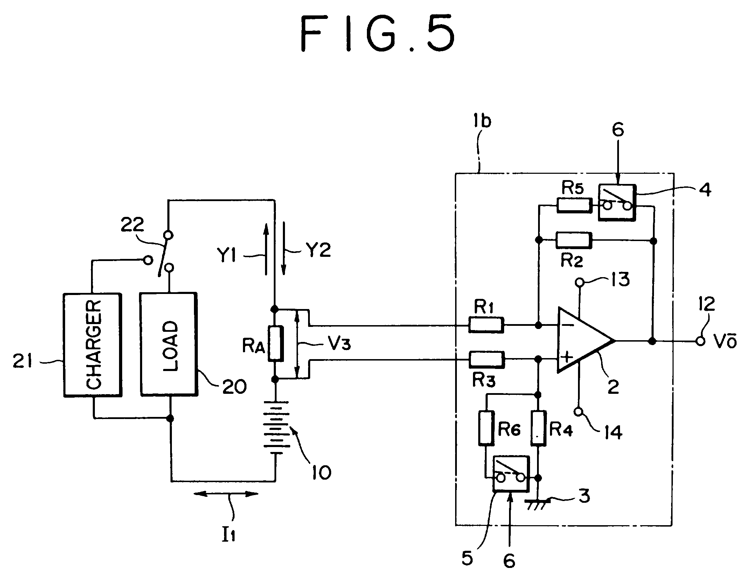

Referring to FIG. 5, there is shown a fifth current measuring circuit arranged by adding a fifth resistor R₅ and a sixth resistor R₆ to the differential amplifier la shown in FIG. 1. More specifically, the fifth resistor R₅ is connected in parallel with the second resistor R₂ through a first switch 4 and the sixth resistor R₆ is connected in parallel with the fourth resistor R₄ through a second switch 5. Further, the first and second switches 4 and 5 are adapted to be turned on/off responding to a first control signal 6 output from a control means, not shown. When the first and second switches 4 and 5 are turned on responding to the first control signal 6 as indicated by the respective broken lines, the resistance value determining the gain of the operational amplifier 2 becomes {R₂·R₅/(R₂ + R₅)}/R₁, which is smaller than the resistance value determining the gain R₂/R₁ in the previous state. Thus, the gain of the operational amplifier 2 can be decreased and, hence, the amplification factor of the differential amplifier 1b can be made smaller.

Accordingly, even when the current flowing through the resistor R_{A} is a large current, it becomes possible, by turning on the first and second switches 4 and 5, to output the potential difference generated between both ends of the resistor R_{A} after amplifying the same by a smaller amplification factor adjusted according to the magnitude of the large current. Thus, it becomes possible to bring the output voltage V₀ of the differential amplifier 1b to such a suitable voltage value as can be measured by a measuring means. That is, currents widely ranging from a large current to a small current can be measured by switching the first and second switches.

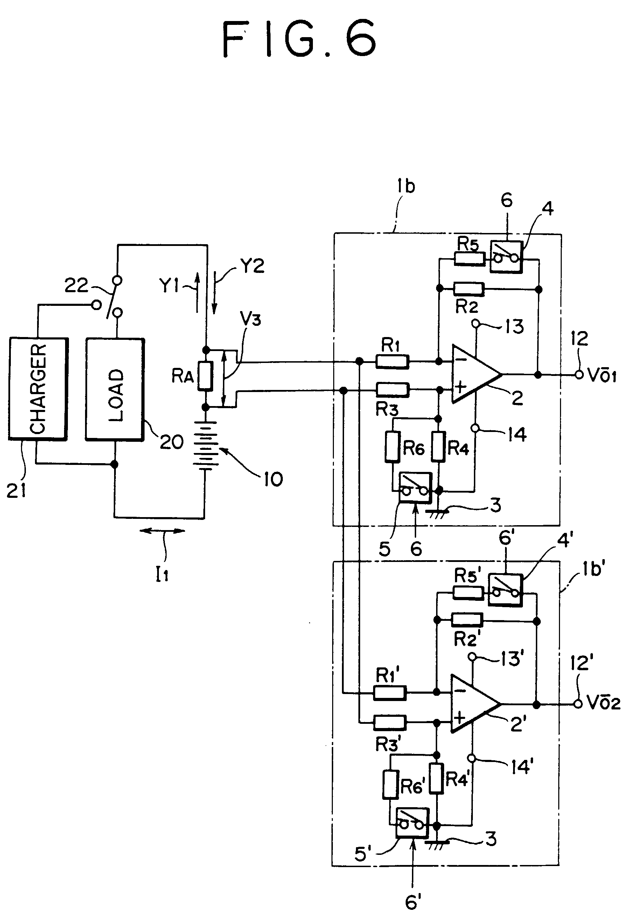

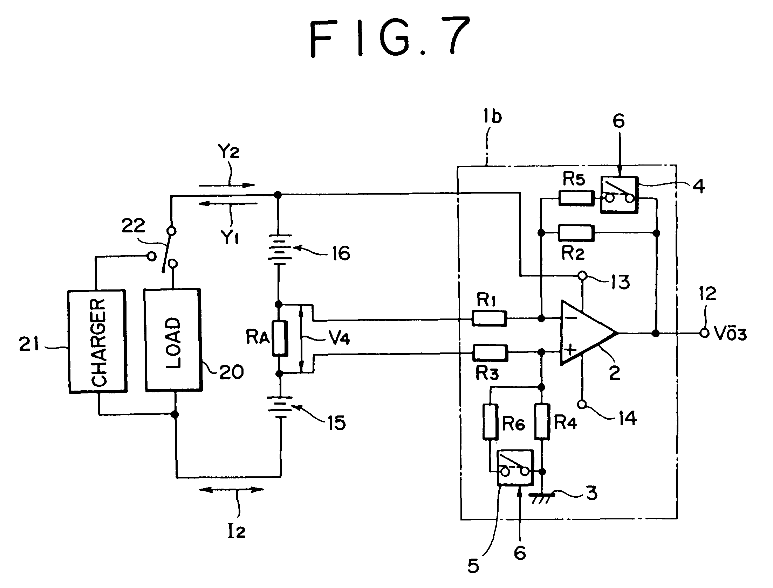

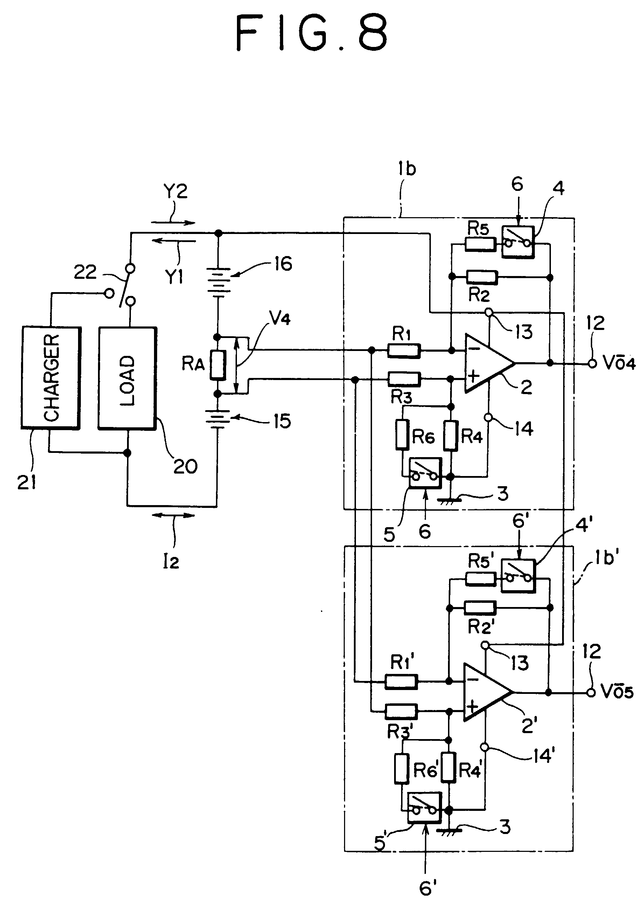

The above described advantage can be equally obtained by the sixth to eighth circuits shown in FIG. 6 to FIG. 8. The sixth circuit shown in FIG. 6 is proved, from its comparison with the second circuit shown in FIG. 2, to be using differential amplifiers 1b and 1b' in place of the differential amplifiers 1a and 1a' in the second circuit. The seventh circuit shown in FIG. 7 is proved, from its comparison with the third circuit shown in FIG. 3, to be using a differential amplifier 1b in place of the differential amplifier la in the third circuit. Further, the eighth circuit shown in FIG. 8 is proved, from its comparison with the fourth circuit shown in FIG. 4, to be using differential amplifiers 1b and 1b' in place of the differential amplifiers 1a and 1a' in the fourth circuit.

Since the sixth to eighth circuits can easily change the amplification factors of the differential amplifiers, they can make measurement of a wide range of currents. Operations and other advantages of the sixth to eighth circuits are equal to those of the second to fourth circuits shown in FIG. 2 to FIG. 4.

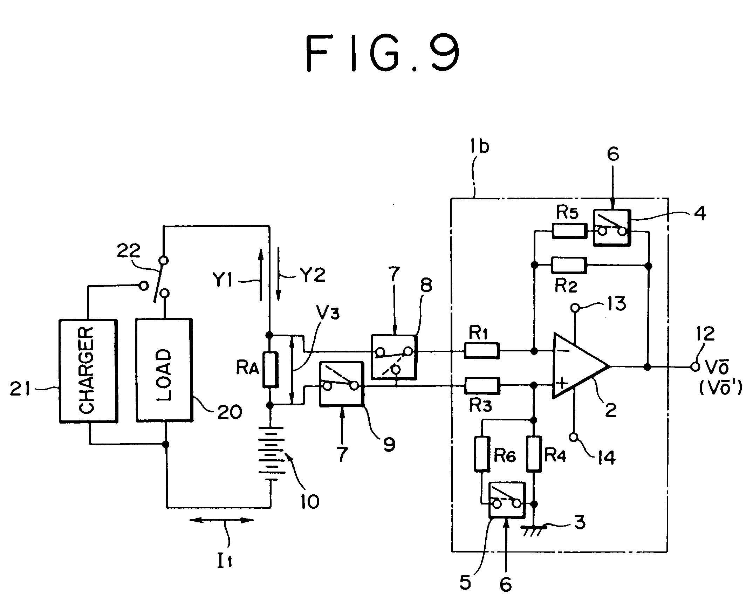

Referring now to FIG. 9, a ninth current measuring circuit will be described. This current measuring circuit is arranged by using a third switch 8 and a fourth switch 9 in addition to the components making up the fifth circuit.

More specifically, there is provided the third switch 8 which, responding to a second control signal 7, either connects one input terminal of the differential amplifier 1b (one end of the first resistor R₁ in FIG. 9) and one end of the resistor R_{A} or isolates that input terminal of-the differential amplifier 1b and that end of the resistor R_{A} and, in addition, short-circuits that input terminal and the other input terminal of the differential amplifier 1b (one end of the third resistor R₃ in FIG. 9). Further, there is provided the fourth switch 9, which similarly responding to the second control signal 7, either connects the other input terminal of the differential amplifier 1b and the other end of the resistor R_{A} or isolates them.

With the third and fourth switches 8 and 9 provided as described above, if both the input terminals of the operational amplifier 2 are short-circuited, an offset/drift voltage V₀' is output from the operational amplifier 2. In measurement of the discharging current and charging current of the battery 10, by correcting the voltage V₀ output from the differential amplifier 1b using the offset/drift voltage V₀', the current measurement can be performed more accurately.

At the time of the measurement, the third switch 8 and the fourth switch 9 are switched to the sides indicated by the broken lines. Thereby, the resistor R_{A} is isolated from the resistor R₁ and the resistor R₃. In addition, the inverting input terminal (- ) and the non-inverting input terminal (+ ) are short-circuited (connected together) through the resistors R₁ and R₃ and, hence, the potential difference between both the input terminals becomes zero. The offset/drift voltage V₀' output from the operational amplifier 2 when both its input terminals are short-circuited is measured by and stored in a processing unit through an A/D converter circuit, which is not shown.

Then, the third and fourth switches 8 and 9 are switched to the sides indicated by the solid lines and the output voltage V₀ of the operational amplifier 2 at this time is measured by the processing unit through the A/D converter circuit, and the difference between the thus measured voltage V₀ and the earlier stored voltage V₀' is obtained. This difference provides a proper current value after correction.

By correcting the output voltage of the operational amplifier at the time of current measurement using the offset/drift voltage, a highly accurate current measuring circuit can be provided economically, without using an expensive operational amplifier of a low offset/low drift voltage type. Further, such a merit is obtained that power consumption in the current measuring circuit can be reduced by turning off the fourth switch 9 thereby isolating the other input terminal of the differential amplifier 1b from the other end of the resistor R_{A} and cutting off the useless current flowing through the resistors R₃ and R₄ when the current measurement is not performed.

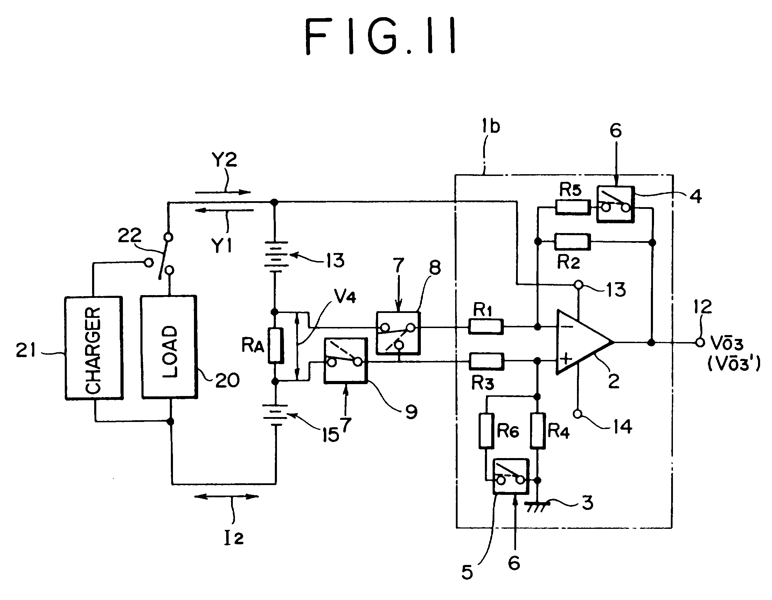

FIG. 11 shows an eleventh circuit having the above-described advantages. This circuit has the arrangement of the seventh circuit shown in FIG. 7 with a third switch 8 and a fourth switch 9 added thereto. Also in this circuit, an offset/drift voltage V_{03'} is similarly measured and stored. Then, the output voltage V₀₃ of the differential amplifier 1b is measured and the difference between this measured voltage V₀₃ and the earlier stored voltage V₀₃^{,} is obtained. Thereby, highly accurate measurement of the discharging current or charging current can be achieved. Further, by turning off the fourth switch 9 when the current I₂ is not measured, power consumption in the current measuring circuit can be reduced.

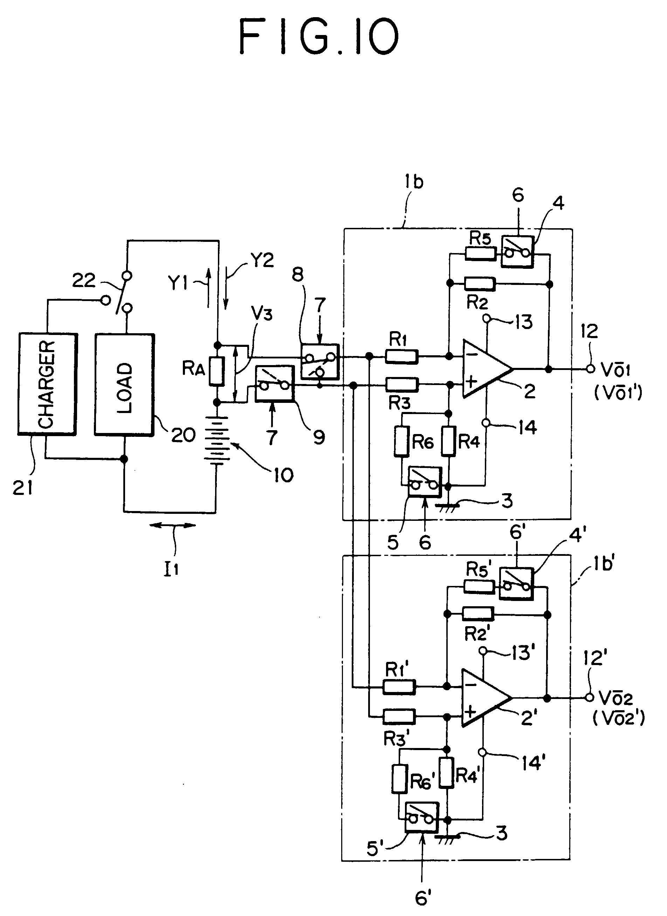

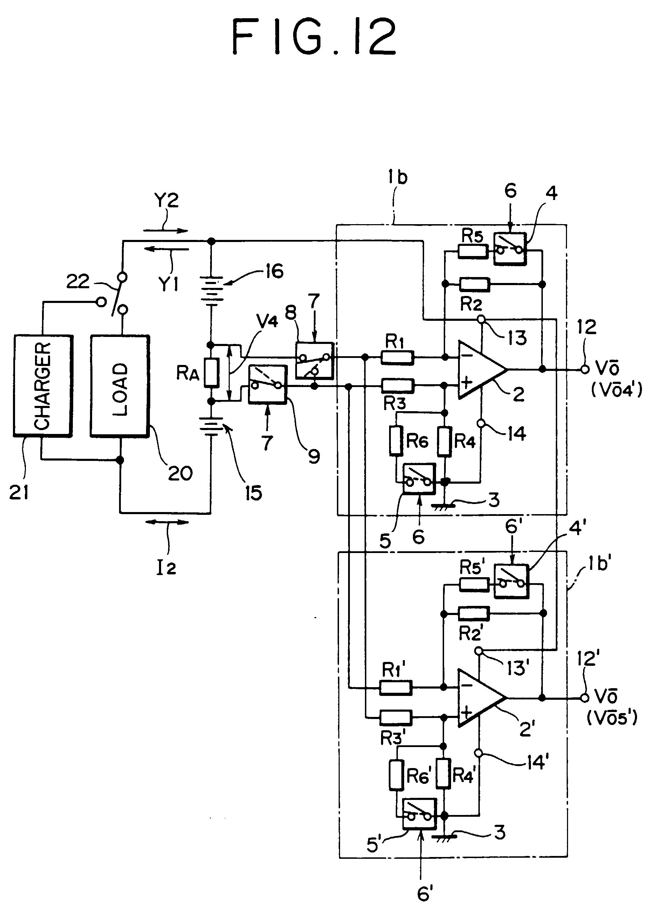

The above described two advantages obtained in the ninth and eleventh circuits are similarly obtained by the respective circuits shown in FIG. 10 and FIG. 12.

The circuit shown in FIG. 10 has the arrangement of the sixth circuit shown in FIG. 6 with a third switch 8 and a fourth switch 9 added thereto. In Fig. 10, the third switch 8 and the fourth switch 9 are switched in response to a second control signal 7 to the side indicated by the broken lines, and an offset/drift voltage V₀₁' or V₀₂' then output from the differential amplifier 1b or 1b' is measured by and stored in a processing unit through an A/D converter circuit, not shown. Then, the third and fourth switches 8 and 9 are switched to the side indicated by the solid lines. The output voltage V₀₁ or V₀₂ at this time is measured by the processing unit through the A/D converter circuit and the difference between the thus measured voltage V₀₁ or V₀₂ and the earlier stored voltage V₀₁' or V₀₂' is obtained.

Thus, highly accurate measurement of the discharging current or charging current of the battery 10 can be achieved and, further, power consumption in the current measuring circuit when no current is measured can be reduced by turning off the fourth switch 9.

FIG. 12 shows an embodiment of the present invention. This embodiment has the arrangement of the eighth circuit shown in FIG. 8 with a third switch 8 and a fourth switch 9 added thereto. Also in this embodiment, an offset/drift voltage V₀₄' or V₀₅' is similarly measured and stored. Then output voltage V₀₄ or V₀₅ of the differential amplifier 1b or 1b' is measured and the difference between this measured output voltage V₀₄ or V₀₅ and the earlier stored voltage V₀₄' or V₀₅' is obtained. Thereby, highly accurate measurement of the discharging current or charging current can be achieved. Further, power consumption in the current measuring circuit when no current is measured can be reduced by turning off the fourth switch 9.

Accordingly, the described embodiment is able to provide a current measuring circuit capable of measuring battery discharging current and charging current over a wide range from a small current to a large current.

## Claims

1. A current measuring circuit for measuring discharging current and charging current of a battery (15,16) divided into first (16) and second (15) parts and selectively connectable to a load (20) or a charger (21);
comprising:
a measuring resistor (R_{A}) for connection in series with said battery (15,16) having a sufficiently low resistance value as not to substantially restrain the output current from said battery (15,16); and
a first differential amplifier (1b) for amplifying a potential difference between both ends of said measuring resistor (R_{A}), said first differential amplifier comprising a first operational amplifier (2), a first resistor (R₁) connected between one end of said measuring resistor (R_{A}) and one input terminal (-) of said first operational amplifier (2), a second resistor (R₂) connected between the one input terminal (-) and the output terminal of said first operational amplifier (2), a third resistor (R₃) connected between the other end of said measuring resistor (R_{A}) and the other input terminal (+) of said first operational amplifier (2), a fourth resistor (R₄) connected between the other input terminal (+) of said first operational amplifier (2) and ground; the resistance value of said first resistor (R₁) being equal to the resistance value of said third resistor (R₃) and the resistance value of said second resistor (R₂) being equal to the resistance value of said fourth resistor (R₄); means (8) for interconnecting the one input terminal and the other input terminal of said first operational amplifier (2) through the first and third resistors (R₁,R₃); calculating means for calculating the difference between an output voltage from said first operational amplifier (2) when the one input terminal and the other input terminal of said first operational amplifier (2) are interconnected and an output voltage from said first operational amplifier when the one input terminal of said first operational amplifier is connected with the one end of said measuring resistor (R_{A}) and the other input terminal of said first operational amplifier is connected with the other end of said measuring resistor (R_{A}); and
a second differential amplifier (1b') for amplifying the potential difference between both ends of said measuring resistor (R_{A}), said second differential amplifier comprising a second operational amplifier (2'), a seventh resistor (R_{1'}) connected between the other end of said measuring resistor and one input terminal (-) of said second operational amplifier (2'), an eighth resistor (R_{2'}) connected between the one input terminal (-) and the output terminal of said second operational amplifier (2'), a ninth resistor (R_{3'}) connected between the one end of said measuring resistor (R_{A}) and the other input terminal (+) of said second operational amplifier (2'), and a tenth resistor (R_{4'}) connected between the other input terminal (+) of said second operational amplifier (2') and ground, the resistance value of said seventh resistor (R_{1'}) being equal to the resistance value of said ninth resistor (R_{3'}) and the resistance value of said eighth resistor (R_{2'}) being equal to the resistance value of said tenth resistor (R_{4'}), wherein the positive power-supply terminals of said first operational amplifier (2) and of said second operational amplifier (2') are connected with the positive voltage output terminal of the first battery part (16) and the negative power-supply terminals of said first operational amplifier (2) and of said second operational amplifier (2') are grounded, wherein the negative voltage output terminal of the first battery part (16) is connected to the one end of the measuring resistor (R_{A}) and wherein the second battery part (15) is connected in series with the measuring resistor (R_{A}) at the other end thereof.

2. A current measuring circuit according to claim 1, further comprising a series connection of a fifth resistor (R₅) and a first switch (4) connected in parallel with said second resistor (R₂); a series connection of a sixth resistor (R₆) and a second switch (5) connected in parallel with said fourth resistor (R₄); a series connection of an eleventh resistor (R_{5'}) and a third switch (4') connected in parallel with said eighth resistor (R_{2'}); and a series connection of a twelfth resistor (R_{6'}) and a fourth switch (5') connected in parallel with said tenth resistor (R_{4'}).

3. A current measuring circuit according to Claim 1 or 2, wherein the resistance value of said measuring resistor (R_{A}) is below 0.1Ω.

## Patentansprüche

1. Strommeßschaltung zum Messen eines Entladestroms und eines Ladestroms einer Batterie, die in erste (16) und zweite (15) Teile aufgeteilt ist und selektiv mit einer Last (20) oder einem Ladegerät (21) verbindbar ist; umfassend:
einen Meßwiderstand (R_{A}) zur Reihenschaltung mit der Batterie (15, 16), die einen ausreichend niedrigen Widerstandswert aufweist, um den Ausgangsstrom von der Batterie (15, 16) im wesentlichen nicht einzuschränken; und
einen ersten Differenzverstärker (1b) zum Verstärken einer Potentialdifferenz zwischen beiden Enden des Meßwiderstands (R_{A}), wobei der erste Differenzverstärker umfaßt: einen ersten Operationsverstärker (2), einen ersten Widerstand (R₁), der zwischen ein Ende des Meßwiderstands (R_{A}) und einen Eingangsanschluß (-) des ersten Operationsverstärkers (2) geschaltet ist, einen zweiten Widerstand (R₂), der zwischen einen Eingangsanschluß (-) und den Ausgangsanschluß des ersten Operationsverstärkers (2) geschaltet ist, einen dritten Widerstand (R₃), der zwischen das andere Ende des Meßwiderstands (R_{A}) und den anderen Eingangsanschluß (+) des ersten Operationsverstärkers (2) geschaltet ist, einen vierten Widerstand (R₄), der zwischen den anderen Eingangsanschluß (+) des ersten Operationsverstärkers (2) und Masse geschaltet ist; wobei der Widerstandswert des ersten Widerstands (R₁) gleich zu dem Widerstandswert des dritten Widerstands (R₃) ist und der Widerstandswert des zweiten Widerstands (R₂) gleich zu dem Widerstandswert des vierten Widerstands (R₄) ist; eine Einrichtung (8) zum Verbinden des einen Eingangsanschlusses und des anderen Eingangsanschlusses des ersten Operationsverstärkers (2) über die ersten und dritten Widerstände (R₁, R₃); eine Berechnungseinrichtung zum Berechnen der Differenz zwischen einer Ausgangsspannung von dem ersten Operationsverstärker (2), wenn der eine Eingangsanschluß und der andere Eingangsanschluß des ersten Operationsverstärkers (2) untereinander verbunden sind, und einer Ausgangsspannung von dem ersten Operationsverstärker, wenn der eine Eingangsanschluß des ersten Operationsverstärkers mit dem einen Ende des Meßwiderstands (R_{A}) verbunden ist und der andere Eingangsanschluß des ersten Operationsverstärkers mit dem anderen Ende des Meßwiderstands (R_{A}) verbunden ist; und
einen zweiten Differenzverstärker (1b') zum Verstärken der Potentialdifferenz zwischen beiden Enden des Meßwiderstands (R_{A}), wobei der zweite Differenzverstärker umfaßt: einen zweiten Operationsverstärker (2'), einen siebten Widerstand (R₁'), der zwischen das andere Ende des Meßwiderstands und einen Eingangsanschluß (-) des zweiten Operationsverstärkers (2') geschaltet ist, einen achten Widerstand (R₂'), der zwischen den einen Eingangsanschluß (-) und den Ausgangsanschluß des zweiten Operationsverstärkes (2') geschaltet ist, einen neunten Widerstand (R₃'), der zwischen das eine Ende des Meßwiderstands (R_{A}) und den anderen Eingangsanschlu0 (+) des zweiten Operationsverstärkers (2') geschaltet ist, und einen zehnten Widerstand (R₄'), der zwischen den anderen Eingangsanschluß (+) des zweiten Operationsverstärkers (2') und Masse geschaltet ist, wobei der Widerstandswert des siebten Widerstands (R₁') gleich zu dem Widerstandswert des neunten Widerstands (R₃') ist und der Widerstandswert des achten Widerstands (R₂') gleich zu dem Widerstandswert des zehnten Widerstands (R₄') ist, wobei die positiven Energieversorgungsanschlüsse des ersten Operationsverstärkers (2) und des zweiten Operationsverstärkers (2') mit dem positiven Spannungsausgangsanschluß des ersten Batterieteils (16) verbunden sind und die negativen Versorgungsanschlüsse des ersten Operationsverstärkers (2) und des zweiten Operationsverstärkes (2') mit Masse verbunden sind, wobei der negative Spannungsausgangsanschluß des ersten Batterieteils (16) mit dem einen Ende des Meßwiderstands (R_{A}) (RA) verbunden ist und wobei der zweite Batterieteil (15) zu dem Meßwiderstand (R_{A}) (RA) an dem anderen Ende davon in Reihe geschaltet ist.

2. Strommeßschaltung nach Anspruch 1, ferner umfassend eine Reihenschaltung eines fünften Widerstands (R₅) und eines ersten Schalters (4), die parallel zu dem zweiten Widerstand (R₂) geschaltet ist; eine Reihenschaltung eines sechsten Widerstands (R₆) und eines zweiten Schalters (5), die parallel zu dem vierten Widerstand (R₄) geschaltet ist; eine Reihenschaltung eines elften Widerstands (R₅') und eines dritten Schalters (4'), die parallel zu dem achten Widerstand (R₂') geschaltet ist; und eine Reihenschaltung eines zwölften Widerstands (R₆') und eines vierten Schalters (5'), die parallel zu dem zehnten Widerstand (R₄') geschaltet ist.

3. Strommeßschaltung nach Anspruch 1 oder 2, dadurch gekennzeichnet, daß der Widerstandswert des Meßwiderstands (R₁) unter 0,1 Ω ist.

## Revendications

1. Circuit de mesure de courant afin de mesurer un courant de décharge et un courant de charge d'une batterie (15, 16) divisée en des première (16) et seconde (15) parties et pouvant être reliée sélectivement à une charge (20) ou à un chargeur (21) ;
comportant :
une résistance de mesure (R_{A}) en vue d'une connexion en série avec ladite batterie (15, 16) possédant une valeur ohmique suffisamment faible de manière à ne pas réduire sensiblement le courant de sortie de ladite batterie (15, 16) ; et
un premier amplificateur différentiel (1b) afin d'amplifier une différence de potentiel entre deux extrémités de ladite résistance de mesure (R_{A}), ledit premier amplificateur différentiel comportant un premier amplificateur opérationnel (2), une première résistance (R₁) montée entre une extrémité de ladite résistance de mesure (R_{A}) et une borne d'entrée (-) dudit premier amplificateur opérationnel (2), une seconde résistance (R₂) montée entre ladite première borne d'entrée (-) et la borne de sortie dudit premier amplificateur opérationnel (2), une troisième résistance (R₃) montée entre l'autre extrémité de ladite résistance de mesure (R_{A}) et l'autre borne d'entrée (+) dudit premier amplificateur opérationnel (2), une quatrième résistance (R₄) montée entre l'autre borne d'entrée (+) dudit premier amplificateur opérationnel (2) et la masse ; la valeur ohmique de ladite première résistance (R₁) étant égale à la valeur ohmique de ladite troisième résistance (R₃) et la valeur ohmique de ladite seconde résistance (R₂) étant égale à la valeur ohmique de ladite quatrième résistance (R₄) ; des moyens (8) pour réunir la première borne d'entrée et l'autre borne d'entrée dudit premier amplificateur opérationnel (2) par l'intermédiaire des première et troisième résistances (R₁, R₃) ; des moyens de calcul afin de calculer la différence entre une tension de sortie dudit premier amplificateur opérationnel (2) lorsque la première borne d'entrée et l'autre borne d'entrée dudit premier amplificateur opérationnel (2) sont réunies et une tension de sortie dudit premier amplificateur opérationnel lorsque la première borne d'entrée dudit premier amplificateur opérationnel est reliée à la première extrémité de ladite résistance de mesure (R_{A}) et l'autre borne d'entrée dudit premier amplificateur opérationnel est reliée à l'autre extrémité de ladite résistance de mesure (R_{A}) ; et
un second amplificateur différentiel (1b') afin d'amplifier la différence de potentiel entre les deux extrémités de ladite résistance de mesure (R_{A}), ledit second amplificateur différentiel comportant un second amplificateur opérationnel (2'), une septième résistance (R_{1'}) montée entre l'autre extrémité de ladite résistance de mesure et une borne d'entrée (-) dudit second amplificateur opérationnel (2'), une huitième résistance (R_{2'}) montée entre la première borne d'entrée (-) et la borne de sortie dudit second amplificateur opérationnel (2'), une neuvième résistance (R_{3'}) montée entre la première extrémité de ladite résistance de mesure (R_{A}) et l'autre borne d'entrée (+) dudit second amplificateur opérationnel (2'), et une dixième résistance (R_{4'}) montée entre l'autre borne d'entrée (+) dudit second amplificateur opérationnel (2') et la masse, la valeur ohmique de ladite septième résistance (R_{1'}) étant égale à la valeur ohmique de ladite neuvième résistance (R_{3'}) et la valeur ohmique de ladite huitième résistance (R_{2'}) étant égale à la valeur ohmique de ladite dixième résistance (R_{4'}), dans lequel les bornes d'alimentation positives dudit premier amplificateur opérationnel (2) et dudit second amplificateur opérationnel (2') sont reliées à la borne de sortie de tension positive de la première partie de batterie (16) et les bornes d'alimentation négatives dudit premier amplificateur opérationnel (2) et dudit second amplificateur opérationnel (2') sont reliées à la masse, dans lequel la borne de sortie de tension négative de la première partie de batterie (16) est reliée à une première extrémité de la résistance de mesure (R_{A}) et dans lequel la seconde partie de batterie (15) est montée en série avec la résistance de mesure (R_{A}) à son autre extrémité.

2. Circuit de mesure de courant selon la revendication 1, comportant en outre un montage série d'une cinquième résistance (R₅) et d'un premier commutateur (4) montés en parallèle avec ladite seconde résistance (R₂), un montage série d'une sixième résistance (R₆) et d'un second commutateur (5) montés en parallèle avec ladite quatrième résistance (R₄) ; un montage en série d'une onzième résistance (R_{5'}) et d'un troisième commutateur (4') montés en parallèle avec ladite huitième résistance (R_{2'}) ; et un montage série d'une douzième résistance (R_{6'}) et d'un quatrième commutateur (5') montés en parallèle avec ladite dixième résistance (R_{4'}).

3. Circuit de mesure de courant selon la revendication 1 ou 2, dans lequel la valeur ohmique de ladite résistance de mesure (R_{A}) est inférieure à 0,1 Ω.
